# EUROPÄISCHE PATENTSCHRIFT

(11) **EP 2 687 069 B1**
(45) Veröffentlichungstag und Bekanntmachung des Hinweises auf die Patenterteilung: **21.10.2015**
(21) Anmeldenummer: 12714943.3
(22) Anmeldetag: 14.03.2012
(51) Int. Cl.: H05K 5/02

(54) **DEKORATIONSVORRICHTUNG**
DECORATION DEVICE
DISPOSITIF DE DÉCORATION

(30) Priorität: 14.03.2011 DE 102011013917
(43) Veröffentlichungstag der Anmeldung: 22.01.2014
(73) Patentinhaber: Vavelidis, Sandra, 71287 Weissach (DE); Cocos-Promotions GmbH, 74223 Flein (DE)
(72) Erfinder: VAVELIDIS, Sandra, 71287 Weissach (DE)
(74) Vertreter: Daub, Thomas
(86) Internationale Anmeldenummer: PCT/EP2012/001134
(87) Internationale Veröffentlichungsnummer: WO 2012/123114

(56) Entgegenhaltungen:
- EP-A2- 2 128 806
- DE-U1- 20 117 697
- FR-A1- 2 941 807
- US-A1- 2009 100 727
- US-A1- 2010 079 996

## Beschreibung

### Stand der Technik

Die Erfindung betrifft eine Dekorationsvorrichtung nach dem Oberbegriff des Anspruchs 1.

Aus EP 2 128 806 A2 ist bereits eine Dekorationsvorrichtung bekannt, die zumindest eine Grundkörpereinheit, welche ein Gehäuse eines USB-Sticks bildet, zumindest eine Speichereinheit zur Speicherung von elektronischen Daten, zumindest eine Übertragungseinheit zur Übertragung von Daten auf die Speichereinheit und/oder von der Speichereinheit, wobei die Übertragungseinheit zumindest eine serielle USB-Schnittstelle aufweist, und zumindest eine Beleuchtungseinheit umfasst.

### Vorteile der Erfindung

Die Erfindung geht aus von einer Dekorationsvorrichtung mit zumindest einer Grundkörpereinheit, die ein Gehäuse eines USB-Sticks bildet, mit zumindest einer Speichereinheit zur Speicherung von elektronischen Daten, mit zumindest einer Übertragungseinheit zur Übertragung von Daten auf die Speichereinheit und/oder von der Speichereinheit, wobei die Übertragungseinheit zumindest eine serielle USB-Schnittstelle aufweist, und mit zumindest einer Beleuchtungseinheit.

Es wird vorgeschlagen, dass die zumindest eine Grundkörpereinheit zumindest ein transparentes Grundkörpervollelement aufweist, das als Vollkörper ausgebildet ist, der zumindest im Wesentlichen entlang jeglicher Erstreckungen des Grundkörpervollelements entlang eines gesamten Verlaufs der Erstreckungen zumindest im Wesentlichen durchgehend aus einem festen Werkstoff ausgebildet ist, und das mit einer Innengravur versehen ist, die vollständig von einem Werkstoff, aus dem das Grundkörpervollelement gebildet wird, umgeben ist, wobei die Innengravur in einem Teilbereich des Grundkörpervollelements eingebracht ist und vollständig von einem Werkstoff, aus dem das Grundkörpervollelement gebildet wird, umgeben ist und wobei die zumindest eine Beleuchtungseinheit zur Beleuchtung der Innengravur vorgesehen ist. Der Ausdruck "transparent" soll hier insbesondere eine Eigenschaft einer Lichtdurchlässigkeit eines Werkstoffs bzw. eines Bauteils definieren, wobei der Werkstoff bzw. das Bauteil insbesondere zumindest mehr als 10 %, bevorzugt mehr als 50 % und besonders mehr als 80 % eines Spektralbereichs eines sichtbaren Lichts durchlässt. Vorzugsweise weist der Spektralbereich des sichtbaren Lichts eine Wellenlänge λ von ungefähr 350 nm bis 800 nm auf. Besonders bevorzugt ist ein Gegenstand, der, zumindest entlang einer Richtung betrachtet, vollständig von dem transparenten Grundkörpervollelement verdeckt ist, von einem Bediener bei einem Blick entlang einer Richtung, die das transparente Grundkörpervollelement und den Gegenstand schneidet, für den Bediener sichtbar. Unter einem "Grundkörpervollelement" soll hier insbesondere ein Element verstanden werden, das insbesondere, entlang drei jeweils zumindest im Wesentlichen senkrecht zueinander verlaufenden Richtungen betrachtet, eine Materialstärke größer als 1 mm, bevorzugt größer als 5 mm und besonders bevorzugt größer als 10 mm aufweist und insbesondere abweichend von einem Element ausgebildet ist, das dazu vorgesehen ist, einen Hohlraum zu einer Aufnahme und/oder zu einer Umschließung von Bauteilen, insbesondere von elektronischen, magnetischen und/oder mechanischen Bauteilen, zu begrenzen. Unter "vorgesehen" soll insbesondere speziell ausgelegt und/oder speziell ausgestattet verstanden werden. Der Ausdruck "im Wesentlichen senkrecht" soll hier insbesondere eine Ausrichtung einer Richtung relativ zu einer Bezugsrichtung definieren, wobei die Richtung und die Bezugsrichtung, insbesondere in einer Ebene betrachtet, einen Winkel von 90° einschließen und der Winkel eine maximale Abweichung von insbesondere kleiner als 8°, vorteilhaft kleiner als 5° und besonders vorteilhaft kleiner als 2° aufweist. Vorzugsweise ist das Grundkörpervollelement als Vollkörper ausgebildet, der zumindest im Wesentlichen entlang jeglicher Erstreckungen des Grundkörpervollelements entlang eines gesamten Verlaufs der Erstreckungen zumindest im Wesentlichen durchgehend aus einem festen Werkstoff ausgebildet ist. Grundsätzlich ist denkbar, dass das Grundkörpervollelement zumindest einen insbesondere kleinen und/oder abgeschlossenen Hohlraum aufweist, der von einem von dem Grundkörpervollelement differierenden Element zumindest im Wesentlichen ausgefüllt ist. Dabei soll unter einem "kleinen und/oder abgeschlossenen Hohlraum" insbesondere ein Hohlraum verstanden werden, der maximal 50%, vorzugsweise maximal 40% und besonders bevorzugt maximal 30% eines Volumens des Grundkörpervollelements aufweist und/oder ein Hohlraum, der vollkommen von dem Grundkörpervollelement umschlossen ist. Ferner soll dabei unter "zumindest im Wesentlichen" insbesondere verstanden werden, dass das Element den Hohlraum zumindest zu 40%, vorzugsweise zumindest zu 60% und besonders bevorzugt zumindest zu 80% ausfüllt. Es sind verschiedene, dem Fachmann als sinnvoll erscheinende Elemente denkbar, welche in das Grundkörpervollelement eingeschlossen und/oder eingebettet werden können, wie beispielsweise Kristalle. Besonders bevorzugt wird das Grundkörpervollelement aus Glas, Kunstharz und/oder PMMA (Polymethylmethacrylat, bzw. Acryl) gebildet. Es ist jedoch auch denkbar, dass das Grundkörpervollelement aus Saphir, aus Diamant, aus Polycarbonat, aus Kristallglas und/oder aus einem anderen, einem Fachmann als sinnvoll erscheinenden Material ausgebildet wird, das dazu geeignet ist, mittels eines Laserverfahrens mit einer 2D- oder 3D-Innengravur versehen zu werden. Besonders bevorzugt weist das aus Glas gebildete Grundkörpervollelement die Innengravur auf, die mittels der Beleuchtungseinheit beleuchtet werden kann. Hierbei ist es denkbar, dass das Grundkörpervollelement zumindest auf einer Seite des Grundkörpervollelements mit einer Folie beschichtet ist. Bevorzugt ist die Folie mit zumindest einem Farbstoff bedruckt. Die Folie kann zudem verschiedene zusätzliche dem Fachmann als sinnvoll erscheinende Eigenschaften aufweisen, wie beispielsweise eine Änderung einer Lichtbrechung usw. Es sind verschiedene Formgebungen für das Grundkörpervollelement denkbar, wie beispielsweise eine Quaderform oder eine Kristallform.

Bevorzugt weist die Grundkörpereinheit zumindest ein Grundkörperelement auf, das zum Schutz eines Übertragungselements der Übertragungseinheit auf das Übertragungselement aufgeschoben werden kann. Somit ist die Dekorationsvorrichtung als USB-Stick ausgebildet. Die Grundkörpereinheit kann hierbei ein Aufnahmeelement zur Aufnahme eines Tragebands, einer Tragekette und/oder andere einem Fachmann als sinnvoll erscheinende Trageelemente aufweisen. Es kann vorteilhaft eine kompakte Dekorationsvorrichtung erreicht werden, die beispielsweise vorteilhaft zum Austausch elektronsicher Daten und/oder elektronischer Informationen genutzt werden kann.

Der Begriff "Innengravur" soll hier insbesondere eine Gravur definieren, die in einem Teilbereich eines Bauteils, insbesondere des Grundkörpervollelements, eingebracht wurde, insbesondere mittels eines Laserverfahrens eingebracht wurde, und vollständig von einem Werkstoff, aus dem das Bauteil gebildet wird, umgeben ist. Es ist jedoch auch denkbar, dass das Grundkörpervollelement alternativ oder zusätzlich zu einer Bearbeitung mittels des Laserverfahrens mittels eines Oberflächenbehandlungsverfahrens bearbeitet wird, wie beispielsweise eines Sandstrahlverfahrens usw., um eine Oberflächenstruktur des Grundkörpervollelements zu ändern. Ferner ist es ebenfalls denkbar, dass das Grundkörpervollelement alternativ oder zusätzlich zur 2D- oder 3D-Laserinnengravur eine mittels eines Gravierverfahrens eingebrachte Oberflächengravur auf zumindest einer Seite des Grundkörpervollelements aufweist. Der Ausdruck "Beleuchtungseinheit" soll hier insbesondere eine Einheit definieren, die zumindest gezielt dazu vorgesehen ist, die Innengravur zu beleuchten. Besonders bevorzugt weist die Beleuchtungseinheit hierbei zumindest ein Beleuchtungselement auf, das als LED ausgebildet ist.

Unter einer "Speichereinheit" soll hier insbesondere eine Einheit verstanden werden, die dazu vorgesehen ist, Daten und/oder Informationen mittels eines elektronischen und/oder magnetischen Speicherungsvorgangs, insbesondere unabhängig von einer Energieversorgung, zu speichern. Bevorzugt umfasst die Speichereinheit zumindest einen Flash-EEPROM (Flash-Speicher) und/oder ein Festplattenlaufwerk zur Speicherung von Daten und/oder Informationen. Es ist jedoch auch denkbar, dass die Speichereinheit eine andere, einem Fachmann als sinnvoll erscheinende Art eines Speichermediums zur Speicherung von Daten und/oder Informationen aufweist. Mittels der erfindungsgemäßen Ausgestaltung der Dekorationsvorrichtung kann vorteilhaft eine Speicherung von Daten erfolgen. Ferner kann vorteilhaft konstruktiv einfach eine Zusatzfunktion für einen Bediener der Dekorationsvorrichtung realisiert werden.

Besonders bevorzugt ist die Übertragungseinheit dazu vorgesehen elektronisch Daten und/oder elektronisch

Informationen mittels einer seriellen, einer parallelen, einer analogen und/oder einer WLAN-Schnittstelle zu übertragen. Die Übertragungseinheit ist bevorzugt dazu vorgesehen, mittels der Schnittstelle kabellos, wie beispielsweise mittels WLAN, Bluetooth usw. und/oder kabelgebunden, wie beispielsweise mittels Firewire usw. mit einem externen Gerät, wie beispielsweise einem PC, einem Laptop, einem Handy und/oder anderen, einem Fachmann als sinnvoll erscheinenden Geräten verbunden zu werden, um Daten auszutauschen. Es können vorteilhaft elektronische Daten und/oder elektronische Informationen mittels der Übertragungseinheit an die Speichereinheit und/oder von der Speichereinheit übertragen werden. Somit können vorteilhaft elektronische Daten und/oder elektronische Informationen eines Bedieners zumindest temporär mittels einer Übertragung der elektronischen Daten und/oder der elektronischen Informationen an die Speichereinheit durch die Übertragungseinheit archiviert werden.

Besonders bevorzugt weist die Übertragungseinheit zumindest ein Übertragungselement auf, das als USB-Stecker ausgebildet ist, insbesondere als USB-Stecker Typ A nach DIN IEC 61076-3-107. Es ist jedoch auch denkbar, dass das Übertragungselement als USB-Stecker 3.0 des Typs B und/oder als ein anderer einem Fachmann als sinnvoll erscheinender Typ eines USB-Steckers ausgebildet ist. Somit kann die Dekorationsvorrichtung besonders vorteilhaft und bedienerfreundlich mit einem externen Gerät zur Übertragung von elektronischen Daten und/oder von elektronischen Informationen verbunden werden.

Ferner wird vorgeschlagen, dass die Dekorationsvorrichtung zumindest eine Steuer- und/oder Regeleinheit umfasst, die dazu vorgesehen ist, zumindest einen Beleuchtungsmodus der Beleuchtungseinheit zu steuern und/oder zu regeln. Unter einer "Steuer- und/oder Regeleinheit" soll insbesondere eine Einheit mit zumindest einer Prozessoreinheit verstanden werden, die auf zumindest ein in einem Speichermittel der Speichereinheit gespeicherten Betriebsprogramm zur Steuerung der Beleuchtung der Beleuchtungseinheit zugreift. Mittels der Steuer- und/oder Regeleinheit kann bevorzugt beispielsweise eine Beleuchtungsstärke, ein Farbwechsel, eine Beleuchtungsausrichtung und/oder andere, einem Fachmann als sinnvoll erscheinende Faktoren der Beleuchtungseinheit gesteuert werden. Zudem ist die Steuer- und/oder Regeleinheit vorzugsweise dazu vorgesehen, eine Übertragung von elektronischen Daten und/oder von elektronischen Informationen auf die Speichereinheit mittels der Übertragungseinheit zu steuern und/oder zu regeln. Besonders bevorzugt kann die Steuer- und/oder Regeleinheit infolge einer durch einen Bediener mittels der Übertragungseinheit auf ein Speichermittel der Speichereinheit übertragenes Betriebsprogramm an bedienerspezifische Anforderungen angepasst und/oder eingestellt werden. Es kann vorteilhaft eine Steuerung der Beleuchtungseinheit erreicht werden.

Vorzugsweise umfasst die Dekorationsvorrichtung zumindest eine Ausgabeeinheit, die dazu vorgesehen ist, zumindest eine Kenngröße der Speichereinheit auszugeben. Die Ausgabeeinheit kann als optische, akustische und/oder als taktile Ausgabeeinheit ausgebildet sein. In einer alternativen Ausgestaltung der erfindungsgemäßen Dekorationsvorrichtung ist es denkbar, dass die Steuer- und/oder Regeleinheit über die Ausgabeeinheit Daten, Bilder, Filme usw. in das Grundkörpervollelement projiziert. Hierbei weist das Grundkörpervollelement zumindest auf einer Seite eine Beschichtung zur Reflexion der mittels der Ausgabeeinheit projizierten Daten, Bilder, Filme usw., um eine für einen Bediener erkennbare Darstellung der mittels der Ausgabeeinheit projizierten Daten, Bilder, Filme usw. zu erhalten. Es kann vorteilhaft einem Bediener ein Status der Speichereinheit ausgegeben werden.

Vorteilhafterweise weist die Ausgabeeinheit zumindest ein optisches Ausgabeelement auf, das eine Kenngröße der Speichereinheit anzeigt. Somit ist die Ausgabeeinheit besonders bevorzugt als optische Ausgabeeinheit ausgebildet. Hierbei kann das Ausgabeelement zur Ausgabe einer Kenngröße der Speichereinheit als LC-Display und/oder als analoges Zeigerinstrument ausgebildet sein. Es ist jedoch auch denkbar, dass die Ausgabeeinheit eine andere, einem Fachmann als sinnvoll erscheinende Ausgestaltung aufweist. Die Kenngröße der Speichereinheit wird vorzugsweise von einer noch verfügbaren Speicherkapazität der Speichereinheit, insbesondere von einer verfügbaren Speicherkapazität eines Speicherelements der Speichereinheit, gebildet. Hierbei kann die Speicherkapazität grafisch, beispielsweise mittels eines Balkensymbols, und/oder als Ziffern dargestellt werden, die eine noch verfügbare Speicherkapazität in Abhängigkeit einer Gesamtspeicherkapazität der Speichereinheit, insbesondere von einem Speicherelement der Speichereinheit, anzeigt. Es ist jedoch auch denkbar, dass die Speicherkapazität mittels eines als Lautsprecher ausgebildeten Ausgabeelements und/oder mittels eines als Schwingungserreger ausgebildeten Ausgabeelements, welches Vibrationen erzeugt, ausgegeben wird. Mittels der erfindungsgemäßen Ausgestaltung der Dekorationsvorrichtung kann konstruktiv einfach eine Speicherkapazität eines Speicherelements der Speichereinheit angezeigt werden.

Zudem wird vorgeschlagen, dass das optische Ausgabeelement zumindest in einem Betriebszustand mittels der Beleuchtungseinheit beleuchtbar ist. Bevorzugt weist die Beleuchtungseinheit hierbei zumindest ein als LED ausgebildetes Beleuchtungselement auf, das dem Ausgabeelement zugeordnet ist. Es ist jedoch auch denkbar, dass das Ausgabelelement und das Beleuchtungselement einstückig ausgebildet sind. Bei einer einstückigen Ausgestaltung des Ausgabelelements und des Beleuchtungselements weist die Ausgabeeinheit und/oder die Beleuchtungseinheit beispielsweise zumindest vier LEDs auf. Eine Illumination aller vier LEDs zur gleichen Zeit würde beispielsweise bedeuten, dass eine Gesamtspeicherkapazität von 100 % einer Speichergröße eines Speicherelements der Speichereinheit zur Speicherung von elektronischen Daten und/oder von elektronischen Informationen zur Verfügung steht. Jede der vier LEDs würde somit beispielsweise 25 % einer Gesamtspeicherkapazität der Speichereinheit darstellen. Besonders bevorzugt wird die Kenngröße der Speichereinheit mittels eines grafischen Balkensymbols auf einem LC-Display angezeigt, das durch ein als LED ausgebildetes Beleuchtungselement der Beleuchtungseinheit beleuchtet wird. Es kann vorteilhaft einem Bediener eine Kenngröße der Speichereinheit bei einer geringen Stärke eines Umgebungslichts angezeigt werden.

Des Weiteren wird vorgeschlagen, dass die Dekorationsvorrichtung zumindest eine Energiespeichereinheit umfasst, die zumindest dazu vorgesehen ist, die Beleuchtungseinheit in zumindest einem Betriebszustand, insbesondere in einem ungekoppelten Zustand der Übertragungseinheit mit einem externen Gerät, mit Energie zu versorgen. Die Energiespeichereinheit ist besonders bevorzugt als wiederaufladbarer Akkumulator ausgebildet. Vorzugsweise ist der Akkumulator in der Grundkörpereinheit angeordnet. Bevorzugt ist die Energiespeichereinheit zusätzlich zur Versorgung der Beleuchtungseinheit in einem ungekoppelten Zustand der Übertragungseinheit mit einem externen Gerät zumindest zur Versorgung der Ausgabeeinheit und/oder der Steuer- und/oder Regeleinheit vorgesehen. Es kann vorteilhaft eine von einem lokalen Energienetz temporär unabhängige Energieversorgung der Dekorationsvorrichtung erreicht werden.

Vorteilhafterweise ist die Energiespeichereinheit mittels eines Übertragungselements der Übertragungseinheit zumindest in einem gekoppelten Zustand des Übertragungselements mit Energie zur Speicherung in der Energiespeichereinheit versorgbar. Besonders bevorzugt wird somit die als wiederaufladbarerer Akkumulator ausgebildete Energiespeichereinheit geladen. Es kann vorteilhaft ein Ladezyklus bei einer Verbindung der Dekorationsvorrichtung mit einem externen Gerät gestartet werden. Somit kann vorteilhaft erreicht werden, dass die Energiespeichereinheit bei einer Verbindung des Übertragungselements und des externen Geräts zumindest teilweise aufgeladen wird.

Des Weiteren wird vorgeschlagen, dass die Ausgabeeinheit dazu vorgesehen ist, zumindest eine Kenngröße der Energieversorgungseinheit auszugeben. Besonders bevorzugt wird die Kenngröße von einer noch vorhandenen Energiekapazität bezogen auf eine Gesamtenergiekapazität der Energiespeichereinheit ausgebeben. Hierbei wird die Kenngröße vorzugsweise von einem grafischen Balkensymbol dargestellt, das mittels eines weiteren Beleuchtungselements der Beleuchtungseinheit beleuchtbar ist. Somit kann ein Bediener vorteilhaft wahrnehmen über welche Zeitspanne der Bediener die Dekorationsvorrichtung in einem zumindest ungekoppelten Zustand des Übertragungselements noch betreiben kann.

Ferner wird in einer alternativen Ausgestaltung vorgeschlagen, dass die Grundkörpereinheit ein Gehäuse einer externen Festplatte bildet. Somit ist die Dekorationsvorrichtung als externe Festplatte ausgebildet. Die Übertragungseinheit weist hierbei insbesondere ein als USB-Buchse ausgebildetes Ubertragungselement auf, das vorzugsweise mittels eines USB-Kabels mit einem externen Gerät zur Übertragung von elektronischen Daten und/oder Informationen verbunden werden kann. Es ist jedoch auch denkbar, dass das Übertragungselement eine andere, einem Fachmann als sinnvoll erscheinende Ausgestaltung aufweist. Es kann vorteilhaft eine Festplatte erreicht werden, die zugleich als Dekorationsvorrichtung ausgebildet ist.

In einer alternativen Ausgestaltung, die hier nicht näher dargestellt ist, weist die Dekorationsvorrichtung alle zuvor beschriebenen Merkmale auf, ausgeschlossen des Merkmals der Speichereinheit. Hierbei bildet die Grundkörpereinheit ein Gehäuse eines USB-Hubs. Somit ist die Dekorationsvorrichtung als USB-Hub ausgebildet. Es kann vorteilhaft ein USB-Hub geschaffen werden, der eine Innengravur, insbesondere eine 2D- oder 3D-Laserinnengravur, aufweist, die mittels der Beleuchtungseinheit beleuchtbar ist.

Ferner wird vorgeschlagen, dass das transparente Grundkörpervollelement und die Speichereinheit über eine Steckverbindung verbunden sind. Dabei kann unter "verbunden" sowohl direkt als auch indirekt verbunden verstanden werden. Unter einer "Steckverbindung" soll in diesem Zusammenhang insbesondere eine form- und/oder kraftschlüssige Verbindung verstanden werden. Vorzugsweise wird die Verbindung über eine Steckbewegung hergestellt. Bevorzugt soll darunter insbesondere eine zerstörungsfrei trennbare Verbindung verstanden werden. Besonders bevorzugt wird die Verbindung insbesondere durch zumindest ein Verbindungsmittel zusammengehalten. Es sind verschiedene, dem Fachmann als sinnvoll erscheinende Verbindungsmittel denkbar, wie insbesondere ein magnetisches Verbindungsmittel und/oder besonders bevorzugt ein Rastmittel. Dabei soll unter einem "Rastmittel" in diesem Zusammenhang insbesondere ein federelastisches Mittel zur Herstellung einer Rastverbindung verstanden werden, das dazu vorgesehen ist, bei einer Montage elastisch ausgelenkt zu werden. Dadurch kann eine besonders schnelle und einfache Montage erreicht werden. Ferner kann eine zuverlässige und konstruktiv einfache Verbindung bereitgestellt werden

Die erfindungsgemäße Dekorationsvorrichtung soll hierbei nicht auf die oben beschriebene Anwendung und Ausführungsform beschränkt sein. Insbesondere kann die erfindungsgemäße Dekorationsvorrichtung zu einer Erfüllung einer hierin beschriebenen Funktionsweise eine von einer hierin genannten Anzahl von einzelnen Elementen, Bauteilen und Einheiten abweichende Anzahl aufweisen.

### Zeichnung

Weitere Vorteile ergeben sich aus der folgenden Zeichnungsbeschreibung. In den Zeichnungen sind Ausführungsbeispiele der Erfindung dargestellt. Die Zeichnungen, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:
- Fig. 1: eine erfindungsgemäße Dekorationsvorrichtung in einer schematischen Darstellung,
- Fig. 2: eine alternative erfindungsgemäße Dekorationsvorrichtung in einer schematischen Darstellung,
- Fig. 3: die alternative erfindungsgemäße Dekorationsvorrichtung mit einem von einer Übertragungseinheit der alternativen erfindungsgemäßen Dekorationsvorrichtung abgenommenen Grundkörperelement einer Grundkörpereinheit der alternativen erfindungsgemäßen Dekorationsvorrichtung in einer schematischen Darstellung,
- Fig. 4: eine Draufsicht auf eine Ausgabeeinheit der alternative erfindungsgemäße Dekorationsvorrichtung in einer schematischen Darstellung,
- Fig. 5: eine weitere alternative erfindungsgemäße Dekorationsvorrichtung in einer schematischen Darstellung und
- Fig. 6: eine Dekorationsvorrichtung in einer schematischen Darstellung.

### Beschreibung der Ausführungsbeispiele

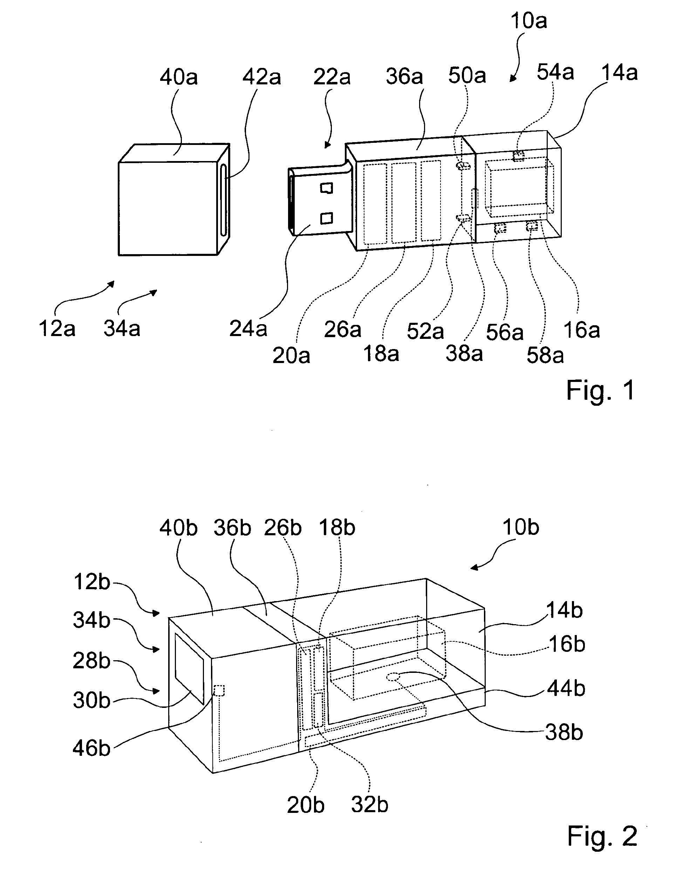

Figur 1 zeigt eine Dekorationsvorrichtung 10a, die als USB-Stick ausgebildet ist. Die Dekorationsvorrichtung 10b umfasst eine Grundkörpereinheit 12a, die ein transparentes Grundkörpervollelement 14a aufweist, das dazu vorgesehen ist, mit einer Innengravur 16a versehen zu werden. Das Grundkörpervollelement 14a ist quaderförmig ausgebildet. Es ist jedoch auch denkbar, dass das Grundkörpervollelement 14a eine andere, einem Fachmann als sinnvoll erscheinende Ausgestaltung aufweist. Die Grundkörpereinheit 12a bildet ein Gehäuse 34a der als USB-Stick ausgebildeten Dekorationsvorrichtung 10a. Hierbei weist die Grundkörpereinheit 12a ein Elektronikgehäuseelement 36a auf, das dazu vorgesehen ist, elektronische Bauteile der als USB-Stick ausgebildeten Dekorationsvorrichtung 10b zu umschließen. Das Elektronikgehäuseelement 36a kann mehrteilig ausgebildet sein oder einteilig. Bei einer einteiligen Ausbildung des Elektronikgehäuseelements 36a werden die elektronischen Bauteile der Dekorationsvorrichtung 10b beispielsweise mit dem Elektronikgehäuseelement 36a vergossen. Bei einer mehrteiligen Ausgestaltung des Elektronikgehäuseelements 36a weist das Elektronikgehäuseelement 36a zwei schalenförmige Hälften auf, in denen die elektronischen Bauteile der Dekorationsvorrichtung 10a angeordnet sind, wobei die schalenförmigen Hälften mittels einer formschlüssigen, kraftschlüssigen und/oder stoffschlüssigen Verbindung in Verbindungsbereichen miteinander verbunden sind. Das Grundkörpervollelement 14a ist mittels einer stoffschlüssigen Verbindung mit dem Elektronikgehäuseelement 36a verbunden. Es ist jedoch auch denkbar, dass das Grundkörpervollelement 14a mittels einer formschlüssigen und/oder kraftschlüssigen Verbindung mit dem Elektronikgehäuseelement 36a verbunden ist, wie insbesondere über Rastelemente 50a, 52a, welche in nicht weiter sichtbare Rastelementausnahmen des Elektronikgehäuseelements 36a greifen. Die Dekorationsvorrichtung 10a umfasst eine Speichereinheit 20a zur Speicherung von elektronischen Daten. Die Speichereinheit 20a ist hierbei im Elektronikgehäuseelement 36a angeordnet. Somit umschließt das Elektronikgehäuseelement 36a die Speichereinheit 20a. Die Speichereinheit 20a umfasst ein als Flash-Speicher ausgebildetes Speicherelement (hier nicht näher dargestellt) zur Speicherung von elektronischen Daten. Ferner ist die Speichereinheit 20a auf einer Elektronikplatine (hier nicht näher dargestellt) der Dekorationsvorrichtung 10a angeordnet, die im Elektronikgehäuseelement 36a gelagert ist. Auf der Elektronikplatine sind weitere, dem Fachmann bereits bekannte elektronische Bauteile zum Betrieb der als USB-Stick ausgebildeten Dekorationsvorrichtung 10b angeordnet.

Des Weiteren weist die Dekorationsvorrichtung 10a eine Beleuchtungseinheit 18a auf, die dazu vorgesehen ist, die in das Grundkörpervollelement 14a eingebrachte Innengravur 16a zu beleuchten. Die Innengravur 16a kann mittels eines Lasers (hier nicht näher dargestellt) auf eine, einem Fachmann bereits bekannte Art und Weise in das Grundkörpervollelement 14a eingebracht werden. Das Grundkörpervollelement 14a wird aus Glas gebildet. Es ist denkbar, dass sich innerhalb des Grundkörpervollelements 14a in einem nicht weiter sichtbaren Hohlraum eingeschlossene bzw. eingebettete Elemente 54a, 56a, 58a befinden. Die Elemente 54a, 56a, 58a würden den Hohlraum vollkommen ausfüllen und wären in das Grundkörpervollelement 14a eingegossen. Die Elemente 54a, 56a, 58a können von Kristallen gebildet sein. Die Innengravur 16a kann als 2D- oder als 3D-Laserinnengravur ausgebildet sein. Die Beleuchtungseinheit 18a zur Beleuchtung der Innengravur 16a weist ein Beleuchtungselement 38a zur Beleuchtung der Innengravur 16a auf. Es ist jedoch auch denkbar, dass die Beleuchtungseinheit 18a mehr als ein Beleuchtungselement 38a zur Beleuchtung der Innengravur 16a aufweist. Das Beleuchtungselement 38a ist als LED ausgebildet. Hierbei kann das Beleuchtungselement 38a als RGB-LED oder als einfarbige LED ausgebildet sein. Das als LED ausgebildete Beleuchtungselement 38a ist hierbei teilweise in dem Elektronikgehäuseelement 36a angeordnet. Ein Lichtkegel des Beleuchtungselements 38a ist auf die Innengravur 16a ausgerichtet. Die Beleuchtungseinheit 18a ist teilweise auf der Elektronikplatine der Dekorationsvorrichtung 10b angeordnet.

Ferner weist die Dekorationsvorrichtung 10a eine Steuer- und/oder Regeleinheit 26a auf, die dazu vorgesehen ist, zumindest einen Beleuchtungsmodus der Beleuchtungseinheit 18a zu steuern und/oder zu regeln. Die Steuer- und/oder Regeleinheit 26a ist ebenfalls auf der Elektronikplatine der Dekorationsvorrichtung 10b angeordnet. Somit wird die Steuer- und/oder Regeleinheit 26a von dem Elektronikgehäuseelement 36a umschlossen. Des Weiteren umfasst die Dekorationsvorrichtung 10b eine Übertragungseinheit 22a zur Übertragung von Daten auf die Speichereinheit 20a und/oder von der Speichereinheit 20a. Die Übertragungseinheit 22a ist hierbei auf einer dem Grundkörpervollelement 14a abgewandten Seite des Elektronikgehäuseelement 36a angeordnet. Die Übertragungseinheit weist 22a eine serielle USB-Schnittstelle auf. Hierbei umfasst die Übertragungseinheit 22a ein als USB-Stecker ausgebildetes Übertragungselement 24a. Das Übertragungselement 24a ist mit der Elektronikplatine der Dekorationsvorrichtung 10a verbunden. Somit kann eine Übertragung von elektronischen Daten in einem gekoppelten Zustand mittels des Übertragungselements 24a auf die Speichereinheit 20a und/oder von der Speichereinheit 20a erfolgen. Das Übertragungselement 24a erstreckt sich ausgehend von der Elektronikplatine der Dekorationsvorrichtung 10b in eine vom Elektronikgehäuseelement 36a abgewandte Richtung. Ferner ist das Übertragungselement 24a dazu vorgesehen, die Dekorationsvorrichtung 10a wirkungsmäßig mit einem externen Gerät, wie beispielsweise einem PC, einem Laptop, einem Mobiltelefon und/oder andere externe Geräte, die eine serielle USB-Schnittstelle mit einem USB-Stecker aufweisen, der korrespondierend mit dem als USB-Stecker ausgebildeten Übertragungselement 24a ausgebildet ist, zur Übertragung von elektronischen Daten zu verbinden. Zum Schutz des Übertragungselements 24a umfasst die Grundkörpereinheit 12a ein Grundkörperelement 40a, das dazu vorgesehen ist, in einem ungekoppelten Zustand des Übertragungselements 24a mit einem externen Gerät auf das Übertragungselement 24a aufgeschoben und/oder aufgesteckt zu werden. Das Grundkörperelement 40a ist hierbei als Schutzkappe ausgebildet. Somit weist das Grundkörperelement 40a eine Ausnehmung 42a auf, in die das Übertragungselement 24a einführbar ist.

Bei einer Verbindung des Übertragungselements 24a mit einem externen Gerät wird mittels der Steuer- und/oder Regeleinheit 26a die Beleuchtungseinheit 18a angesteuert. Hierdurch wird die Innengravur 16a bei einem gekoppelten Zustand des Übertragungselements 24a mit einem externen Gerät mittels des Beleuchtungselements 38a angeleuchtet. Es ist denkbar, dass die Steuer- und/oder Regeleinheit 26a dazu vorgesehen ist, mittels eines auf einem Speicherelement der Speichereinheit 20a gespeicherten Betriebsprogramms ein Farbwechsel des als LED ausgebildeten Beleuchtungselements 38a zu steuern und/oder zu regeln. Ferner ist es denkbar, dass die Steuer- und/oder Regeleinheit 26a dazu vorgesehen ist, in Abhängigkeit von einer noch verfügbaren Speicherkapazität des als Flash-Speicher ausgebildeten Speicherelements der Speichereinheit 20a das Beleuchtungselement 38a anzusteuern, wie beispielsweise zu dimmen und/oder bevor eine maximale Speicherkapazität erreicht wird ein Blinken des Beleuchtungselements 38a hervorzurufen.

In Figuren 2 bis 6 sind alternative Ausführungsbeispiele dargestellt. Im Wesentlichen gleichbleibende Bauteile, Merkmale und Funktionen sind grundsätzlich mit den gleichen Bezugszeichen beziffert. Zur Unterscheidung der Ausführungsbeispiele sind den Bezugszeichen der Ausführungsbeispiele die Buchstaben a bis d hinzugefügt. Die nachfolgende Beschreibung beschränkt sich im Wesentlichen auf die Unterschiede zu dem ersten Ausführungsbeispiel in der Figur 1, wobei bezüglich gleichbleibender Bauteile, Merkmale und Funktionen auf die Beschreibung des ersten Ausführungsbeispiels in der Figur 1 verwiesen werden kann.

Figur 2 zeigt eine alternative Dekorationsvorrichtung 10b, die als USB-Stick ausgebildet ist. Die Dekorationsvorrichtung 10b umfasst eine Grundkörpereinheit 12b, die ein transparentes Grundkörpervollelement 14b aufweist, das dazu vorgesehen ist, mit einer Innengravur 16a versehen zu werden. Das Grundkörpervollelement 14b ist quaderförmig ausgebildet. Die Grundkörpereinheit 12b bildet ein Gehäuse 34b der als USB-Stick ausgebildeten Dekorationsvorrichtung 10b. Hierbei weist die Grundkörpereinheit 12b ein Elektronikgehäuseelement 36b auf, das dazu vorgesehen ist, elektronische Bauteile der als USB-Stick ausgebildeten Dekorationsvorrichtung 10b zu umschließen. Die Dekorationsvorrichtung 10b umfasst eine Speichereinheit 20b zur Speicherung von elektronischen Daten. Die Speichereinheit 20b ist hierbei im Elektronikgehäuseelement 36b angeordnet. Somit umschließt das Elektronikgehäuseelement 36b die Speichereinheit 20b. Die Speichereinheit 20b umfasst ein als Flash-Speicher ausgebildetes Speicherelement (hier nicht näher dargestellt) zur Speicherung von elektronischen Daten. Das Elektronikgehäuseelement 36b weist ferner einen Aufnahmefortsatz 44b auf, der dazu vorgesehen ist, das Grundkörpervollelement 14b zumindest teilweise aufzunehmen. Der Aufnahmefortsatz 44b ist einstückig an das Elektronikgehäuseelement 36b angeformt. Hierbei weist der Aufnahmefortsatz 44b eine Aufnahmefläche auf, die sich zumindest im Wesentlichen senkrecht zu einer Fläche des Elektronikgehäuseelement 36b erstreckt an der das Grundkörpervollelement 14b mit dem Elektronikgehäuseelement 36b verbunden ist. Die Aufnahmefläche des Aufnahmefortsatzes 44b erstreckt sich über eine gesamte Erstreckung des Grundkörpervollelements 14b.

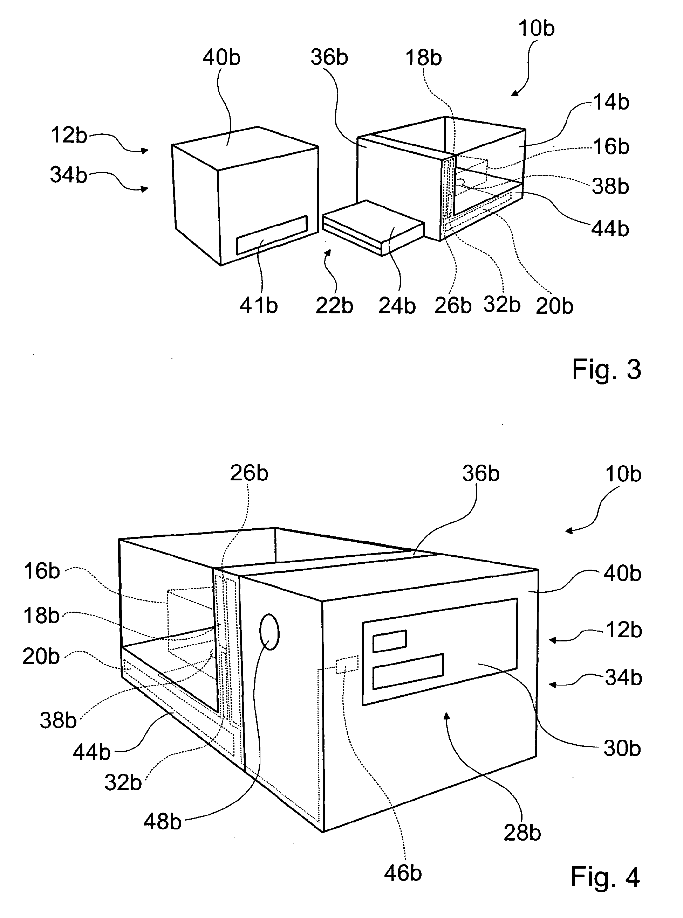

Des Weiteren weist die Dekorationsvorrichtung 10b eine Beleuchtungseinheit 18b auf, die dazu vorgesehen ist, die in das Grundkörpervollelement 14b eingebrachte Innengravur 16b zu beleuchten. Hierzu weist die Beleuchtungseinheit 18b ein als LED ausgebildetes Beleuchtungselement 38b auf. Das Beleuchtungselement 38b ist in dem Aufnahmefortsatz 44b angeordnet. Ferner weist die Dekorationsvorrichtung 10b eine Steuer- und/oder Regeleinheit 26b auf, die dazu vorgesehen ist, zumindest einen Beleuchtungsmodus der Beleuchtungseinheit 18b zu steuern und/oder zu regeln. Des Weiteren umfasst die Dekorationsvorrichtung 10b eine Übertragungseinheit 22b zur Übertragung von elektronischen Daten auf die Speichereinheit 20b und/oder von der Speichereinheit 20b auf (Figur 3). Die Übertragungseinheit 22b weist eine serielle USB-Schnittstelle auf. Hierbei umfasst die Übertragungseinheit 22b ein als USB-Stecker ausgebildetes Übertragungselement 24b. Das Übertragungselement 24b ist auf einer dem Grundkörpervollelement 14b abgewandten Seite des Elektronikgehäuseelements 36b angeordnet. Zum Schutz des Übertragungselements 24b umfasst die Grundkörpereinheit 12b ein abnehmbares Grundkörperelement 40b, das dazu vorgesehen ist, in einem ungekoppelten Zustand des Übertragungselements 24b mit einem externen Gerät auf das Übertragungselement 24b aufgeschoben und/oder aufgesteckt zu werden. Das Grundkörperelement 40b ist hierbei als Schutzkappe ausgebildet. Somit weist das Grundkörperelement 40b eine Ausnehmung 42b auf, in die das Übertragungselement 24b einführbar ist.

Zudem umfasst die Dekorationsvorrichtung 10b eine Ausgabeeinheit 28b, die dazu vorgesehen ist, zumindest eine Kenngröße der Speichereinheit 20b auszugeben (Figur 4). Die Ausgabeeinheit 28b ist an dem als Schutzkappe ausgebildeten Grundkörperelement 40b an einer der Ausnehmung 42b zur Aufnahme des Übertragungselements 24b abgewandten Seite des Grundkörperelements 40b angeordnet. Die Ausgabeeinheit 28b weist ein optisches Ausgabeelement 30b auf, das die Kenngröße der Speichereinheit 20b anzeigt. Das optische Ausgabeelement 30b ist als LC-Display ausgebildet. Es ist jedoch auch denkbar, dass das Ausgabeelement 30b eine andere, einem Fachmann als sinnvoll erscheinende Ausgestaltung aufweist. Die Kenngröße der Speichereinheit 20b wird als grafisches Balkensymbol im Ausgabeelement 30b dargestellt, das dazu vorgesehen ist, einem Bediener in Abhängigkeit einer Menge an elektronischen Daten und/oder einer Größe der gesamten elektronischen Daten, die auf dem als Flash-Speicher ausgebildeten Speicherelement gespeichert sind, eine noch verfügbare Speicherkapazität des als Flash-Speicher ausgebildeten Speicherelements anzuzeigen. Je nach Menge bzw. je nach Größe der elektronischen Daten, die auf dem als Flash-Speicher ausgebildeten Speicherelement gespeichert sind, ändert sich eine Länge und/oder eine angezeigte Füllung des grafischen Balkensymbols.

Die Ausgabeeinheit 28b wird mittels eines Aufschiebens auf das Übertragungselement 24b mittels des Übertragungselements 24b mit der Steuer- und/oder Regeleinheit 26b elektronisch verbunden. Hierbei weist die Ausnehmung 42b zur Aufnahme des Übertragungselements 24b eine serielle USB-Schnittstelle auf, die einen mit dem Übertragungselement 24b korrespondierenden USB-Stecker aufweist. Die Information bezüglich der Kenngröße der Speichereinheit 20b werden nach einem erfolgten Aufschieben des Grundkörperelements 40b und eines wirkungsmäßigen Verbindens mit der Steuer- und/oder Regeleinheit 26b mittels der Ausgabeeinheit 28b angezeigt. Das optische Ausgabeelement 30b ist in einem Betriebszustand mittels der Beleuchtungseinheit 18b beleuchtbar. Hierzu weist die Beleuchtungseinheit 18b ein weiteres als LED ausgebildetes Beleuchtungselement 46b auf, das in dem als Schutzkappe ausgebildeten Grundkörperelement 40b angeordnet ist.

Zu einer Versorgung des weiteren Beleuchtungselements 46b und der Ausgabeeinheit 28b weist die Dekorationsvorrichtung 10b eine Energiespeichereinheit 32b auf, die dazu vorgesehen ist, die Beleuchtungseinheit 18b und die Ausgabeeinheit 28b in zumindest einem Betriebszustand mit Energie zu versorgen. Die Energiespeichereinheit 32b ist in dem Elektronikgehäuseelement 36b angeordnet. Hierbei ist die Energiespeichereinheit 32b als wiederaufladbarer Akkumulator ausgebildet. Die Energiespeichereinheit 32b ist mittels des Übertragungselements 24b der Übertragungseinheit 22b in einem mit einem externen Gerät gekoppelten Zustand des Übertragungselements 24b mit Energie zur Speicherung in der Energiespeichereinheit 32b versorgbar. Somit wird die als wiederaufladbarer Akkumulator ausgebildete Energiespeichereinheit 32b in einem mit einem externen Gerät gekoppelten Zustand des Übertragungselements 24b geladen. Das Beleuchtungselement 38b zur Beleuchtung der Innengravur 16b kann mittels einer Energieversorgung durch die Energiespeichereinheit 32b in einem mit einem externen Gerät ungekoppelten Zustand des Übertragungselements 24b die Innengravur 16b beleuchten, bis die gespeicherte Energie der Energiespeichereinheit 32b aufgebraucht ist. Die Beleuchtungseinheit 18b umfasst zur Beleuchtung der Innengravur 16b in einem mit einem externen Gerät ungekoppelten Zustand des Übertragungselements 24b ein Bedienelement 48b, das dazu vorgesehen ist, infolge einer Betätigung durch einen Bediener das Beleuchtungselement 38b ein- und/oder auszuschalten (Figur 4). Die Ausgabeeinheit 28b ist hierbei dazu vorgesehen, eine als Ladezustand und/oder als Energiefüllgrad ausgebildete Kenngröße der Energiespeichereinheit 32b auszugeben. Hierbei wird ein grafisches Batteriesymbol im Ausgabeelement 30b angezeigt, das je nach Ladezustand und/oder Energiefüllgrad der Energiespeichereinheit 32b grafisch eine Füllung ändert. Es ist jedoch auch denkbar, dass die Kenngröße der Energiespeichereinheit 32b mittels eines anderen, einem Fachmann als sinnvoll erscheinenden Symbols grafisch angezeigt wird. Hinsichtlich weiteren, in der Beschreibung der Figuren 2 bis 4 nicht beschriebenen Merkmalen und Funktionen der Dekorationsvorrichtung 10b darf auf die Beschreibung der Figur 1 verwiesen werden.

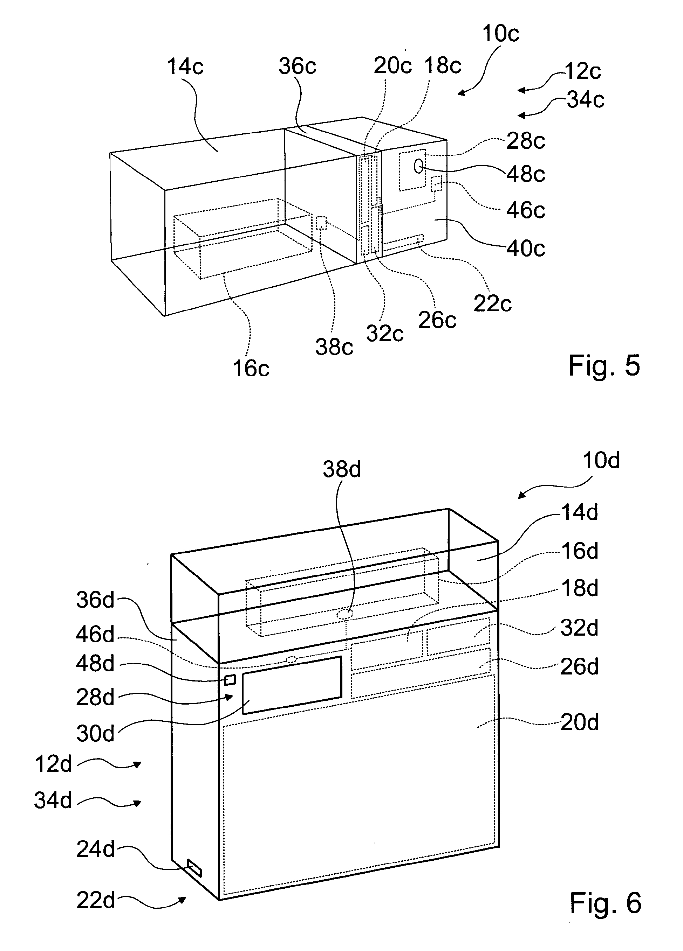

Figur 5 zeigt eine weitere alternative Dekorationsvorrichtung 10c. Die Dekorationsvorrichtung 10c weist eine zumindest im Wesentlichen analoge Ausgestaltung wie die in der Beschreibung der Figuren 2 bis 4 beschriebene Dekorationsvorrichtung 10b auf. Die Dekorationsvorrichtung 10c ist als USB-Stick ausgebildet ist. Ferner umfasst die Dekorationsvorrichtung 10c eine Grundkörpereinheit 12c, die ein transparentes Grundkörpervollelement 14c aufweist, das dazu vorgesehen ist, mit einer Innengravur 16c versehen zu werden. Das Grundkörpervollelement 14c ist quaderförmig ausgebildet. Die Grundkörpereinheit 1 2c bildet ein Gehäuse 34c der als USB-Stick ausgebildeten Dekorationsvorrichtung 10c. Hierbei weist die Grundkörpereinheit 12c ein Elektronikgehäuseelement 36c auf, das dazu vorgesehen ist, elektronische Bauteile der als USB-Stick ausgebildeten Dekorationsvorrichtung 10c zu umschließen. Das Grundkörpervollelement 14c ist auf einer einer Übertragungseinheit 22c abgewandten Seite des Elektronikgehäuseelements 36c angeordnet. Hierbei erstreckt sich das Grundkörpervollelement 14c über eine gesamte Fläche der der Übertragungseinheit 22c abgewandten Seite des Elektronikgehäuseelements 36c. Hinsichtlich weiterer Merkmale und Funktionen der Dekorationsvorrichtung 10c wird auf die Beschreibung der Figur 1 bzw. der Figuren 2 bis 4 verwiesen.

Figur 6 zeigt eine weitere alternative Dekorationsvorrichtung 10d, die als externe Festplatte ausgebildet ist. Die Dekorationsvorrichtung 10d umfasst eine Grundkörpereinheit 12d, die ein transparentes Grundkörpervollelement 14d aufweist, das dazu vorgesehen ist, mit einer Innengravur 16d versehen zu werden. Das Grundkörpervollelement 1 4d ist quaderförmig ausgebildet. Die Grundkörpereinheit 12d bildet ein Gehäuse 34d der als externen Festplatte ausgebildeten Dekorationsvorrichtung 10d. Hierbei weist die Grundkörpereinheit 12d ein Elektronikgehäuseelement 36d auf, das dazu vorgesehen ist, elektronische Bauteile der Dekorationsvorrichtung 10d zu umschließen. Die Dekorationsvorrichtung 10d umfasst eine Speichereinheit 20d zur Speicherung von elektronischen Daten. Die Speichereinheit 20d ist hierbei im Elektronikgehäuseelement 36d angeordnet. Somit umschließt das Elektronikgehäuseelement 36d die Speichereinheit 20d. Die Speichereinheit 20d umfasst hierbei ein scheibenförmiges Speicherelement (hier nicht näher dargestellt) und einen bewegbaren Lesekopf (hier nicht näher dargestellt) zum Auslesen von elektronischen Daten von dem Speicherelement und/oder zum Aufspielen von elektronischen Daten auf das Speicherelement. Des Weiteren weist die Dekorationsvorrichtung 10d eine Übertragungseinheit 22d zur Übertragung von Daten auf die Speichereinheit 20d und/oder von der Speichereinheit 20d auf. Die Übertragungseinheit 22d weist ein als USB-Buchse ausgebildetes Übertragungselement 24b auf. Das Übertragungselement 24b ist dazu vorgesehen, mittels eines korrespondierenden USB-Kabels mit einem externen Gerät zu einem Datenaustausch verbunden zu werden.

Ferner weist die Dekorationsvorrichtung 10d eine Steuer- und/oder Regeleinheit 26d, eine Ausgabeeinheit 28d und eine Energiespeichereinheit 32d auf. Die Steuer- und/oder Regeleinheit 26d, die Ausgabeeinheit 28d und die Energiespeichereinheit 32d sind in dem Elektronikgehäuseelement 36d angeordnet. Hinsichtlich einer Funktion der einzelnen Einheiten der Dekorationsvorrichtung 10d darf auf die Beschreibung der Figur 1 bzw. der Figuren 2 bis 4 verwiesen werden.

**Bezugszeichen**

| | | | |
|---|---|---|---|
| 10 | Dekorationsvorrichtung | 36 | Elektronikgehäuseelement |
| 12 | Grundkörpereinheit | 38 | Beleuchtungselement |
| 14 | Grundkörpervollelement | 40 | Grundkörperelement |
| 16 | Innengravur | 42 | Ausnehmung |
| 18 | Beleuchtungseinheit | 44 | Aufnahmefortsatz |
| 20 | Speichereinheit | 46 | Beleuchtungselement |
| 22 | Übertragungseinheit | 48 | Bedienelement |
| 24 | Übertragungselement | 50 | Rastelement |
| 26 | Steuer- und/oder Regeleinheit | 52 | Rastelement |
| 28 | Ausgabeeinheit | 54 | Element |
| 30 | Ausgabeelement | 56 | Element |
| 32 | Energiespeichereinheit | 58 | Element |
| 34 | Gehäuse | | |

## Patentansprüche

1. Dekorationsvorrichtung mit zumindest einer Grundkörpereinheit (12a; 12b; 12c;) die ein Gehäuse (34a; 34b; 34c) eines USB-Sticks bildet, mit zumindest einer Speichereinheit (20a; 20b; 20c;) zur Speicherung von elektronischen Daten, mit zumindest einer Übertragungseinheit (22a; 22b; 22c;) zur Übertragung von Daten auf die Speichereinheit (20a; 20b; 20c;) und/oder von der Speichereinheit (20a; 20b; 20c;) wobei die Übertragungseinheit (22a; 22b; 22c;) zumindest eine serielle USB-Schnittstelle aufweist, und mit zumindest einer Beleuchtungseinheit (18a; 18b; 18c;)
wobei
die zumindest eine Grundkörpereinheit (12a; 12b; 12c;) zumindest ein transparentes Grundkörpervollelement (14a; 14b; 14c; 14d) aufweist, das als Vollkörper ausgebildet ist, der zumindest im Wesentlichen entlang jeglicher Erstreckungen des Grundkörpervollelements entlang eines gesamten Verlaufs der Erstreckungen zumindest im Wesentlichen durchgehend aus einem festen Werkstoff ausgebildet ist, **gekennzeichnet dadurch, dass**
das Grundkörpervollelement (14a;14b;14c) mit einer Innengravur (16a; 16b; 16c;) versehen ist, wobei die Innengravur (16a; 16b; 16c; ) in einem Teilbereich des Grundkörpervollelements (14a; 14b; 14c; ) eingebracht ist und vollständig von einem Werkstoff, aus dem das Grundkörpervollelement (14a; 14b; 14c; ) gebildet wird, umgeben ist und wobei die zumindest eine Beleuchtungseinheit (18a; 18b; 18c; ) zur Beleuchtung der Innengravur (16a; 16b; 16c;) vorgesehen ist.

2. Dekorationsvorrichtung nach einem der vorhergehenden Ansprüche,
**gekennzeichnet durch** zumindest eine Steuer- und/oder Regeleinheit (26a; 26b; 26c;) die dazu vorgesehen ist, zumindest einen Beleuchtungsmodus der Beleuchtungseinheit (18a; 18b; 18c;) zu steuern und/oder zu regeln.

3. Dekorationsvorrichtung nach einem der vorhergehenden Ansprüche,
**gekennzeichnet durch** zumindest eine Ausgabeeinheit (28b; 28c;) die dazu vorgesehen ist, zumindest eine Kenngröße der Speichereinheit (20b; 20c; ) auszugeben.

4. Dekorationsvorrichtung nach Anspruch 3,
**dadurch gekennzeichnet, dass** die Ausgabeeinheit (28b; 28c;) zumindest ein optisches Ausgabeelement (30b; 30c;) aufweist, das eine Kenngröße der Speichereinheit (20b; 20c;) anzeigt.

5. Dekorationsvorrichtung nach Anspruch 4,
**dadurch gekennzeichnet, dass** das optische Ausgabeelement (30b; 30c;) zumindest in einem Betriebszustand mittels der Beleuchtungseinheit (18b; 18c,) beleuchtbar ist.

6. Dekorationsvorrichtung nach einem der vorhergehenden Ansprüche,
**gekennzeichnet durch** zumindest eine Energiespeichereinheit (32b; 32c;) die zumindest dazu vorgesehen ist, die Beleuchtungseinheit (18b; 18c;) in zumindest einem Betriebszustand mit Energie zu versorgen.

7. Dekorationsvorrichtung nach Anspruch 6,
**dadurch gekennzeichnet, dass** die Energiespeichereinheit (32b; 32c;) mittels eines Ubertragungselements (24b; 24c;) der Übertragungseinheit (22b; 22c;) zumindest in einem gekoppelten Zustand des Übertragungselements (24b; 24c;) mit Energie zur Speicherung in der Energiespeichereinheit (32b; 32c;) versorgbar ist.

8. Dekorationsvorrichtung nach den Ansprüchen 3 und 6,
**dadurch gekennzeichnet, dass** die Ausgabeeinheit (28b; 28c; ) dazu vorgesehen ist, zumindest eine Kenngröße der Energiespeichereinheit (32b; 32c;) auszugeben.

9. Dekorationsvorrichtung nach einem der vorhergehenden Ansprüche,
**dadurch gekennzeichnet, dass** das transparente Grundkörpervollelement (14a; 14b; 14c; ) und die Speichereinheit (20a; 20b; 20c;) über eine Steckverbindung verbunden sind.

## Claims

1. Decoration device with at least one base body unit (12a; 12b; 12c) that forms a housing (34a; 34b; 34c) of a USB flash drive, with at least one storage unit (20a; 20b; 20c) for storing electronic data, with at least one transfer unit (22a; 22b; 22c) for transferring data onto the storage unit (20a; 20b; 20c) and/or from the storage unit (20a; 20b; 20c), wherein the transfer unit (22a; 22b; 22c) comprises at least one serial USB interface, and with at least one illuminating unit (18a; 18b; 18c), wherein the at least one base body unit (12a; 12b; 12c) comprises at least one transparent base body solid element (14a; 14b; 14c) that is embodied as a solid body implemented, at least substantially along any extensions of the base body solid element, along an entire contour of the extensions, at least substantially contiguously of a solid material,
**characterised in that**
the base body solid element (14a; 14b; 14c) is provided with an interior engraving (16a; 16b; 16c), wherein the interior engraving (16a; 16b; 16c) is applied in a partial region of the base body solid element (14a; 14b; 14c) and is entirely surrounded by a material of which the base body solid element (14a; 14b; 14c) is made, and wherein the at least one illuminating unit (18a; 18b; 18c) is provided for illuminating the interior engraving (16a; 16b; 16c).

2. Decoration device according to one of the preceding claims,
**characterised by**
at least one control and/or regulation unit (26a; 26b; 26c), which is provided for controlling and/or regulating at least one illuminating mode of the illuminating unit (18a; 18b; 18c).

3. Decoration device according to one of the preceding claims,
**characterised by**
at least one output unit (28b; 28c), which is provided to output at least one parameter of the storage unit (20b; 20c).

4. Decoration device according to claim 3,
**characterised in that**
the output unit (28b; 28c) comprises at least one optical output element (30b; 30c), which displays a parameter of the storage unit (20b; 20c).

5. Decoration device according to claim 4,
**characterised in that**
the optical output element (30b; 30c) can be illuminated by means of the illuminating unit (18b; 18c) in at least one operating state.

6. Decoration device according to one of the preceding claims,
**characterised by**
at least one energy storage unit (32b; 32c), which is at least provided for supplying the illuminating unit (18b; 18c) with energy in at least one operating state.

7. Decoration device according to claim 6,
**characterised in that**
the energy storage unit (32b; 32c) can be supplied, by means of a transfer element (24b; 24c) of the transfer unit (22b; 22c), with energy for storage in the energy storage unit (32b; 32c) at least in a coupled state of the transfer element (24b; 24c).

8. Decoration device according to claims 3 and 6,
**characterised in that**
the output unit (28b; 28c) is provided to output at least one parameter of the energy storage unit (32b; 32c).

9. Decoration device according to one of the preceding claims,
**characterised in that**
the transparent base body solid element (14a; 14b; 14c) and the storage unit (20a; 20b, 20c) are connected via a plug connection.

## Revendications

1. Dispositif de décoration avec au moins une unité de solide basique (12a; 12b; 12c), laquelle forme un boîtier (34a ; 34b ; 34c) d'une clé USB, avec au moins une unité de mémorisation (20a ; 20b ; 20c) pour mémoriser des données électroniques, avec au moins une unité de transfert (22a ; 22b ; 22c) pour transférer des données sur l'unité de mémorisation (20a ; 20b ; 20c) et/ou de l'unité de mémorisation (20a ; 20b ; 20c), l'unité de transfert (22a ; 22b ; 22c) présentant au moins une interface USB sérielle, et avec au moins une unité d'illumination (18a ; 18b ; 18c),
cependant que l'au moins une unité de solide basique (12a ; 12b ; 12c) présente au moins un élément compact de solide basique (14a ; 14b ; 14c) transparent, lequel est implémenté comme un solide compact consistant, le long de toutes extensions de l'élément compact de solide basique (14a ; 14b ; 14c), le long d'un cours entier des extensions, au moins substantiellement continûment d'un matériau solide,
**caractérisé en ce que**
l'élément compact de solide basique (14a ; 14b ; 14c) est pourvu d'une gravure intérieure (16a ; 16b ; 16c), la gravure intérieure (16a ; 16b ; 16c) étant appliquée dans une zone partielle de l'élément compact de solide basique (14a ; 14b ; 14c) et étant entièrement entourée d'un matériau duquel l'élément compact de solide basique (14a ; 14b ; 14c) est formé,
l'au moins une unité d'illumination (18a ; 18b ; 18c) étant prévue à illuminer la gravure intérieure (16a ; 16b ; 16c).

2. Dispositif de décoration selon l'une quelconque des revendications précédentes,
**caractérisé par**
au moins une unité de contrôle et/ou régulation (26a ; 26b ; 26c), laquelle est prévue à contrôler et/ou régler au moins un mode d'illumination de l'unité d'illumination (18a ; 18b ; 18c).

3. Dispositif de décoration selon l'une quelconque des revendications précédentes,
**caractérisé par**
au moins une unité de sortie (28b ; 28c), laquelle est prévue à délivrer au moins un paramètre de l'unité de mémorisation (20b ; 20c)

4. Dispositif de décoration selon la revendication 3,
**caractérisé en ce que**
l'unité de sortie (28b ; 28c) présente au moins un élément de sortie (30b ; 30c) optique, lequel indique un paramètre de l'unité de mémorisation (20b ; 20c).

5. Dispositif de décoration selon la revendication 4,
**caractérisé en ce que**
l'élément de sortie (30b ; 30c) optique est illuminable par le biais de l'unité d'illumination (18b ; 18c) dans au moins un état opératif.

6. Dispositif de décoration selon l'une quelconque des revendications précédentes,
**caractérisé par**
au moins une unité de stockage d'énergie (32b ; 32c), laquelle est au moins prévue à fournir de l'énergie à l'unité d'illumination (18b ; 18c) dans au moins un état opératif.

7. Dispositif de décoration selon la revendication 6,
**caractérisé en ce que**
l'unité de stockage d'énergie (32b ; 32c) peut être fournie d'énergie pour stockage dans l'unité de stockage d'énergie (32b ; 32c) par le biais d'un élément de transfert (24b ; 24c) de l'unité de transfert (22b ; 22c) dans au moins un état couplé de l'élément de transfert (24b ; 24c).

8. Dispositif de décoration selon les revendications 3 et 6,
**caractérisé en ce que**
l'unité de sortie (28b ; 28c) est prévue à sortir au moins un paramètre de l'unité de stockage d'énergie (32b ; 32c).

9. Dispositif de décoration selon l'une quelconque des revendications précédentes,
**caractérisé en ce que**
l'élément compact de corps basique (14a ; 14b ; 14c) transparent et l'unité de mémorisation (20a ; 20b ; 20c) sont jointes par une fiche de raccordement.
